# EUROPEAN PATENT APPLICATION

(11) **EP 4 765 198 A1**
(43) Date of publication of application: **24.06.2026**
(21) Application number: 24222561.3
(22) Date of filing: 20.12.2024
(51) Int. Cl.: H01L 21/67

(54) **EXPOSING A COMPONENT CARRIER STRUCTURE TO A PROCESSING MEDIUM BY DELIMITING AND DISCHARGING THE PROCESSING MEDIUM IN A WORKING SPACE OF AN EXPOSURE HEAD**

(71) Applicant: AT & S Austria Technologie & Systemtechnik Aktiengesellschaft, 8700 Leoben-Hinterberg (AT)
(72) Inventor: Oggioni, Stefano Sergio, 8700 Leoben (AT); Kirchheimer, Karl Philipp, 8700 Leoben (AT)
(74) Representative: Dilg, Haeusler, Schindelmann Patentanwaltsgesellschaft mbH

(57) **Abstract**

A head (100) for exposing a surface (112) of a component carrier structure (102) to a treatment with a processing medium (104), the head (100) comprising at least one ejection opening (106) for ejecting the processing medium (104) to the surface (112), a peripheral wall (108) delimiting a working space (110) to contain the ejected processing medium (104) when the head (100) is in its working position with respect to the surface (112) to be exposed to the processing medium (104), and a processing medium outlet (118) configured to discharge the ejected processing medium (104) from the working space (110). Electrostatic discharge safety may be a feature of an embodiment.

## Description

The invention relates to a head for exposing a surface of a component carrier structure to a treatment with a processing medium, to an apparatus for processing a surface of a component carrier structure by a processing medium, and to a method of manufacturing a package, and to a method of exposing a surface of a component carrier structure to a treatment with a processing medium.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

During manufacturing of a component carrier (like a printed circuit board), it may be treated, for instance while being still integrally connected with other component carriers in a component carrier structure (such as a panel) by a water jet, for example for cutting the component carrier structure into individual component carriers.

It is an object of the invention to efficiently treat a surface of a component carrier structure.

In order to achieve the object defined above, a head for exposing a surface of a component carrier structure to a treatment with a processing medium, an apparatus for processing a surface of a component carrier structure by a processing medium, and a method of exposing a surface of a component carrier structure to a treatment with a processing medium according to the independent claims are provided.

According to an exemplary embodiment, a head for exposing a surface of a component carrier structure to a treatment with a processing medium is provided, the head comprising at least one ejection opening for ejecting the processing medium to the surface, a peripheral wall delimiting a working space to contain the ejected processing medium when the head is in its working position with respect to the surface to be exposed to the processing medium, and a processing medium outlet configured to discharge the ejected processing medium from the working space.

According to another exemplary embodiment of the invention, an apparatus for processing a surface of a component carrier structure by a processing medium is provided, wherein the apparatus comprises a head having the above mentioned features for exposing the surface of the component carrier structure to the processing medium.

According to still another exemplary embodiment of the invention, a method of exposing a surface of a component carrier structure to a treatment with a processing medium is provided, the method comprising ejecting the processing medium to the surface by at least one ejection opening of a head, arranging a peripheral wall of the head for delimiting a working space to contain the ejected processing medium when the head is in its working position with respect to the surface exposed to the processing medium, and discharging the ejected processing medium from the working space via a processing medium outlet of the head.

In the context of the present application, the term "component carrier structure" may particularly denote a physical body, for instance having a plate-like shape, which may be a preform of a plurality of still integrally connected component carriers or which may be a readily manufactured component carrier. For instance, such a component carrier may be a printed circuit board or an integrated circuit substrate. For example, such a still integrally connected preform may be a panel or an array of component carriers (of the aforementioned type or of another type). Such a panel or array may comprise a plurality of still integrally connected component carriers prior to separation (for instance by dicing, for example using a water jet beam).

In the context of the present application, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, and an IC (integrated circuit) substrate. For example, a component carrier may be a rigid-flex carrier, or a flexible substrate. A component carrier may also be a hybrid board combining different ones of the above-mentioned types of component carriers. In particular, a component carrier may comprise a stack comprising a plurality of electrically conductive layer structures and/or electrically insulating layer structures.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures, which preferably may be arranged in a parallel manner, by the application of mechanical pressure and/or heat.

In the context of the present application, the term "layer structure" may particularly denote a continuous layer, a patterned layer or a plurality of nonconsecutive islands within a common plane.

In the context of the present application, the term "head" may particularly denote a processing medium handling section of an apparatus for processing a surface of a component carrier structure. Such a head may comprise structures for ejecting, spatially delimiting and discharging processing medium with respect to a working space delimited by head and component carrier structure.

In the context of the present application, the term "ejection opening" may particularly denote a processing medium release opening for transferring processing medium from a head into a working space for supplying processing medium to the working space and from there towards a target position or area on the component carrier structure to be processed. For instance, such an ejection opening may comprise a nozzle and/or any other conduit, channel or tubing.

In the context of the present application, the term "peripheral wall" may particularly denote a partially or completely circumferentially extending structure delimiting and thereby controlling flow of processing medium as a barrier structure. For example, such a peripheral wall may be made of a solid, porous or preferably fibrous material. The peripheral wall may be rigid or preferably flexible or elastically deformable. For instance, the peripheral wall may have an annular shape.

In the context of the present application, the term "working space" may particularly denote a spatial volume delimited partially by the head, in particular including its peripheral wall, and partially by the component carrier structure. The working space may be a circumferentially surrounded region in which working medium ejected by at least one ejection opening may be contained partially or entirely.

In the context of the present application, the term "working position of the head" may particularly denote a position of the head in which the head, together with the component carrier structure, delimits the working space for containing or maintaining processing medium or at least a significant portion thereof inside a working space delimited by component carrier structure and the head when being located in the working position. In the working position of the head, the latter is ready for processing a surface of the component carrier structure by processing medium ejected, delimited, controlled and/or discharged by the head. In the working position of the head, the head faces the component carrier structure for ejecting processing medium thereon.

In the context of the present application, the term "processing medium outlet" may particularly denote any physical structure configured so that processing medium is enabled to leave the working space through the processing medium outlet towards a destination (such as a waste container or a recycling or recovery station). For example, the processing medium outlet may extend into the working space. For instance, the processing medium outlet may comprise one or a plurality of separate outlet openings. In particular, the processing medium outlet may comprise at least one conduit, at least one channel and/or at least one tubing for discharging the processing medium from the working space.

In the context of the present application, the term "discharging processing medium from the working space" may particularly denote a process of actively or passively removing processing medium out of the working space in a defined way. In particular, the discharging may include sucking processing medium out of the working space via at least one processing medium outlet. This may be done actively, for instance by a suction pump. Additionally or alternatively, this may also be done passively, for example by using phenomena such as the Bernoulli effect and/or the Venturi effect.

In the context of the present application, the term "processing medium" may particularly denote a flow of mobile medium usable for processing (for instance cutting, cavity forming and/or cleaning) a component carrier structure when being ejected thereon to hit the latter. For example, such a processing medium may comprise a liquid, a gas and/or solid particles. In an embodiment, the processing medium may comprise at least one fluid, preferably a liquid, optionally comprising solid particles. For instance, the liquid may be water, and the particles may be silicon oxide or sand. However, it may also be possible that the fluid comprises nitrogen or air and the particles comprise dry ice.

In the context of the present application, the term "main surface" of a body may particularly denote one of two largest opposing surfaces of the body or outermost opposing surfaces of the body. The main surfaces may be connected by circumferential side walls. The thickness of a body, such as a component carrier or another component carrier structure, may be defined by the distance between the two opposing main surfaces.

According to an exemplary embodiment of the invention, an apparatus and a head thereof may be provided which allow to expose a surface of a component carrier structure (such as a panel for manufacturing printed circuit boards or integrated circuit substrates) to a processing medium (such as a water jet) for treating or processing the component carrier in a defined way (for instance for water jet cutting), for example during a manufacturing or maintenance process. Advantageously, the head may be equipped with one or more ejection openings (such as at least one ejection nozzle) for ejecting the processing medium onto the surface, for example under high pressure. Moreover, a peripheral wall of the head may, together with the component carrier structure to be treated or processed, spatially restrict or delimit a working space when the head is in its working position so that the ejected processing medium or at least a major portion thereof remains contained within the working space without flowing excessively out of the working space in an unlimited way along a surface of the component carrier structure so as to reach undesired sections thereof. Beneficially, a processing medium outlet of the head may be adapted for discharging processing medium out of the working space. Such a controlled or active discharging (for instance by sucking or pumping) of processing fluid out of the working space delimited by head and component carrier structure may make sure that the processing medium remaining in the working space can be reliably drained from the working space towards a desired destination. This may reliably prevent undesired accumulation or overflow of processing medium in the working space. Consequently, exemplary embodiments may lead to a precisely controlled and failure robust processing of a component carrier structure with a processing medium.

In the following, further exemplary embodiments of the head, the apparatus and the method will be explained.

In an embodiment, the head may be aligned such that the ejected processing medium is ejected perpendicular to the surface of the component carrier. Alternatively, the head may be aligned such that the ejected processing medium is ejected inclined to the surface of the component carrier. Preferably, the ejection opening may be aligned such that the ejected processing medium is ejected perpendicular to the main surface of the head. Alternatively, the ejection opening may be aligned such that the ejected processing medium is ejected inclined to the main surface of the head. Concerning the distance between the closest point of the head and the component carrier structure, the closer the better. For instance, a corresponding distance may be 0.5 mm (or less) up to a few millimeters, for instance up to 5 mm. In different embodiments, said distance may be related to the pressure of the processing medium and the type of material being processed.

In an embodiment, the flow of discharging the processing medium and the flow of ejecting the processing medium may be the same. Alternatively, they may be different from each other (in particular, the flow of discharging may be higher). This may ensure to prevent or inhibit flooding the surface of the component carrier structure, since processing medium can be efficiently transported away.

In an embodiment, the use of a waterjet can also be used for a PCB with assembled components. Brushes of the peripheral wall may conform to the uneven surface of the assembled PCB with components mounted on the surface.

In an embodiment, the head comprises an electrostatic discharge unit configured to remove at least part of electrostatic charge from the surface to be exposed to the processing medium. For instance, such electrostatic charge may be created due to friction between the component carrier structure on the one hand and the processing medium and/or the head on the other hand. In order to electrically protect sensitive electronic circuitry and/or chips of, in and/or on the component carrier structure from damage or breakdown of electrostatic discharge , the electrostatic discharge unit can take care of the removal of such electrostatic charge from the component carrier structure

In an embodiment, at least one electrically conductive element and/or the peripheral wall is configured as at least part of the electrostatic discharge unit. For instance, the ESD protection can be accomplished via the peripheral wall of the head. For example, the peripheral wall may be formed at least partially of an electrically conductive material. In a preferred embodiment, the peripheral wall may be formed using fibers at least part of which being electrically conductive. Such electrically conductive fibers may remove electrostatic charge from the component carrier structure, for instance by establishing a connection to an electric ground potential or another electric reference potential. This provides an efficient ESD protection.

In an embodiment, the at least one ejection opening is configured to eject the processing medium as a jet-beam. Such a jet-beam may be a laterally confined beam of processing medium directed at high pressure onto the surface of the component carrier structure for processing the latter.

In an embodiment, the at least one ejection opening is configured to eject the processing medium onto the component carrier structure with a high pressure, preferably at least 1000 bar. When hitting the component carrier structure with such a high pressure, for example 3000 bar, the ejected processing medium may mechanically impact the component carrier structure. Such a mechanical impact may lead for instance to the formation of a cavity, a through hole, a cutting line, etc. It may also be possible to mechanically impact the surface of the component carrier structure by the pressurized processing medium for cleaning purposes, for instance supported by a chemical cleaning agent.

In an embodiment, a delimiting structure of the head delimiting the working space has a surface structure configured for preventing collection of particles and/or scraps of the processed component carrier structure in the working space. For example, the delimiting structure may comprise a base body (such as a base plate) and the peripheral wall connected with it. Exemplary features of this surface configuration are an adaptation of the surface tension and/or the fluid dynamic setting of the discharging processing medium. In particular, particle-scraps of component carrier structure materials such as resin, conductive material, fillers and/or inorganic insulating material such as glass may be prevented from accumulation.

In an embodiment, the peripheral wall is circumferentially closed so that the head and the surface to be exposed to the processing medium form a closed volume. Thus, the peripheral wall may form a closed annular structure. In another example, the peripheral wall may form a closed structure having an irregular shape or a shape being different from a circular shape or an elliptical shape. Together with a base structure of the head, a cap may be formed which may be closed at the bottom side by a surface portion of the component carrier structure. Preferably, the described configuration of the working space may lead to a processing medium tight configuration for maintaining the processing medium outlet within the working space.

In an embodiment, the peripheral wall is a non-homogeneous or an inhomogeneous structure. In particular, the peripheral wall may be formed by a plurality of substructures which may be moved mutually with respect to each other. This may provide a peripheral wall with flexibility or deformability which may help to maintain the processing medium inside the working space even when the head moves relatively to the component carrier structure, for instance for scanning a surface thereof.

In an embodiment, the peripheral wall is deformable, in particular elastically deformable. When configuring the peripheral wall of a material which can be (preferably elastically) deformed, the peripheral wall may change its shape under mechanical impact, and may return into its initial state when the impact is released. This may promote the processing medium sealing capability, for example even when the head moves on and along the component carrier structure.

In an embodiment, the peripheral wall is a porous wall, in particular having closed pores and/or open pores. In particular, the pores may be provided with a pore dimension, void percentage and/or wall material configured to maintain the processing medium inside the working space. Advantageously, such a porous wall may also have deformable properties which may additionally contribute to keep the processing medium in the working space.

In an embodiment, the peripheral wall comprises fibers, in particular electrically conductive fibers such as carbon fibers and/or fibers grouped to form a brush. In an embodiment, it may also be possible that fibers are made conductive by surface treatment and/or by mixing materials compositions to achieve electrical conductivity. Advantageously, electrically conductive fibers (such as carbon fibers or metallic fibers) may be used for forming a brush of a peripheral wall of a head according to an exemplary embodiment of the invention. Such a fiber-based brush may be manufactured with low effort and may provide elasticity and deformability.

In an embodiment, at least part of the fibers is configured to constitute at least part of the electrostatic discharge unit. For this purpose, said fibers may be made of an electrically conductive material. When the head is in its working position, said electrically conductive fibers may be in direct physical contact with the component carrier structure for efficiently removing electric charge from there. Further advantageously, the electrically conductive fibers may be electrically grounded for conducting the electric charge from the component carrier structure via the fibers to an electric ground potential.

In an embodiment, adjacent ones of the fibers are laterally placed and/or spaced with respect to each other and/or at least part of the fibers is provided with a surface energy to maintain the processing medium inside the working space. The same may apply to pores for the porous material. In view of surface tension characteristics of the processing medium in combination with surface tension characteristics of the fibers or porous material, the processing medium may be forced to remain inside the working space. The mutual spacing between different fibers may be such that processing medium is prevented from flowing out of the working space through gaps between different fibers. At the same time, said mutual spacing may promote flexibility, elasticity and/or deformability of the fibers for maintaining a sealing interface to the component carrier structure even when the head moves relative to the component carrier structure.

In an embodiment, the fibers have a diameter in a range from 1 µm to 100 µm, in particular in a range from 5 µm to 10 µm. In an embodiment, the fibers have a length in a range from 1 mm to 100 mm, in particular in a range from 5 mm to 20 mm. For instance, the fibers may have an aspect ratio, i.e. a ratio between length and diameter, of at least 10, in particular of at least 100. Thus, the fibers may be oblong filaments. Such fibers form an excellent basis for the peripheral wall.

In an embodiment, the fibers have a number of fibers per length of the peripheral wall in a range from 10000 filaments/cm to 100000 filaments/cm. Said density can be for example 60000 filaments/cm. Thus, the fibers may be arranged sufficiently dense for disabling flow of processing medium between adjacent fibers. At the same time, the density of the fibers can be selected so as to maintain elastic deformability of a brush formed of said fibers.

In an embodiment, the peripheral wall is configured to contact the surface to be exposed to the processing medium when the head is in its working position. By such direct physical contact between peripheral wall and component carrier structure, the processing medium may be maintained reliably within the working space without the risk of outflow. At the same time, such a direct physical contact may, when the peripheral wall is electrically conductive and is connected to an electric potential (such as ground potential), provide an ESD protection for the component carrier structure. When the peripheral wall is formed as a brush of (preferably electrically conductive) fibers, even scratching of the component carrier structure may be reliably prevented.

In an embodiment, the head is configured to maintain the processing medium in the working space even when moving the head along the surface to be exposed to the processing medium. This can be accomplished by configuring the peripheral wall to be elastically deformable when the head is displaced horizontally relative to the component carrier structure with physical contact of the peripheral wall with the component carrier structure. This combines ESD protection of the component carrier structure with reliable sealing of processing medium while ensuring a high degree of flexibility for using the head and the corresponding apparatus.

In an embodiment, the processing medium outlet comprises an outlet section directly connected to the working space for draining the processing medium. This may reliably prevent overflow of processing medium out of the working space.

In an embodiment, the processing medium outlet comprises a plurality of separate outlet sections each connected to the working space and each for discharging the processing medium. Such an embodiment allows a homogeneous draining of processing medium from different portions of the working space. In an example, the shape and/or extension of the plurality of separate outlet sections may be the same. In another example, the shape and/or extension of at least one of the plurality of separate outlet sections may be different to the shape and/or extension of at least one other of the plurality of separate outlet sections.

In an embodiment, the processing medium outlet comprises a bifurcated network of flow channels. For instance, a plurality of separate outlet sections may be connected by the bifurcated network so as to obtain a single overall fluidic outlet. This allows to suck the processing medium through multiple outlet sections by a single suction device connected to said overall fluidic outlet.

In an embodiment, the processing medium outlet has a structured shape, in particular an elongated, circumferential and/or concentric shape. Hence, the geometry of the processing medium outlet may be adapted in accordance with a desired processing medium drain scheme.

In an embodiment, the processing medium outlet has a protruding section which protrudes into an inside of the working space. For instance, a tube section of the processing medium outlet may extend from a base body of the head down into the working space. For instance, such a protruding section of the processing medium outlet may function similar as a straw and may suck processing medium close to the surface of the component carrier structure out of the working space. In an example, the elongation of the protruding section (in particular parallel to a thickness direction of the component carrier structure) may be different, in particular shorter, than the elongation of the peripheral wall (in particular parallel to a thickness direction of the component carrier structure). In another example, the elongation of the protruding section (in particular parallel to thickness direction of the component carrier structure) may be the same as the elongation of the peripheral wall (in particular parallel to a thickness direction of the component carrier structure).

In an embodiment, the head comprises a suction device connected to the processing medium outlet for sucking the processing medium out of the working space. In particular, the suction device may be configured to create a suction force at the processing medium outlet, for instance triggered by a flow of the processing medium entering the working space. For example, this may be accomplished through a Bernoulli effect or a Venturi pipe.

In an embodiment, the suction device comprises a suction pump. For example, such a suction pump may be a piston pump, a peristaltic pump, a membrane pump, etc. A suction pump may actively draw processing medium out of the working space.

In an embodiment, the suction device is provided with a sucking capability for processing medium comprising a fluid, in particular a liquid, and solid particles and/or scraps of the component carrier structure. This may be promoted by the fact that the holding or working space may be full of liquid, due to the peripheral wall. Resin, conductive material, fillers, inorganic insulating material (such as glass) and other materials of the component carrier structure removed by the pressurized processing medium may be drained from the working space by the suction device.

In an embodiment, the processing medium outlet is associated to the peripheral wall so that the processing medium passes through said, in particular porous and/or fibrous, peripheral wall to pass through the processing medium outlet. When integrating the one or more processing medium outlets in the peripheral wall, the head can be manufactured in a particular compact way.

In an embodiment, the peripheral wall is spaced from the surface to be exposed to the processing medium by a distance when the head is in its working position. Advantageously, a gap may be formed between the peripheral wall and the component carrier structure, so that scratching of the component carrier structure by the peripheral wall can be excluded. When the gap is formed to be sufficiently small, outflow of processing medium through said gap may be inhibited or even eliminated.

In an embodiment, the distance between the peripheral wall and the surface to be exposed to the processing medium is such that due to the viscosity and/or surface tension of the processing medium a passage between the peripheral wall and the surface to be exposed to the processing medium is prevented. For instance when the processing medium comprises particles (such as sand), its viscosity may be sufficiently large that outflow of such processing medium through a gap between peripheral wall and component carrier structure may be prevented.

In an embodiment, the at least one ejection opening comprises at least one ejection nozzle. Such a nozzle may be embodied as a pipe or tube of varying cross sectional area so that it can be used to direct or modify the flow of the processing medium. An ejection nozzle may be configured to control the rate of flow, speed, direction, mass, shape, and/or the pressure of the stream of processing medium that emerges from the nozzle. In a nozzle, the velocity of the processing medium may be increased.

In an embodiment, the apparatus is configured for removing material of the component carrier structure by the processing medium. This may involve beam shaping of the processing medium ejected through the ejection opening and provision of the ejected processing medium with a sufficiently high pressure of for example at least 1000 bar.

In an embodiment, the apparatus is configured for forming a cavity or a through hole in the component carrier structure by the processing medium. Such a cavity in a component carrier structure or a component carrier thereof may be a blind hole used for embedding a component, preferably an electronic component, therein. If medium partially remains in the cavity or through hole, a high pressure rinse or ultrasound may be used to clean it. In an embodiment, the apparatus may comprise two different ejection parts inside of the machine, the first ejection part can apply the processing medium to form the through hole or cavity or cutting the component carrier first, and then it may be switched to the second ejection part to clean the through hole or cavity or component carrier by high pressure water. It may also be possible that the apparatus has two tanks, one for processing medium and one for water or another chemical for cleaning or etching the through hole or cavity or component carrier.

In an embodiment, the apparatus is configured for singularizing the component carrier structure into a plurality of individual component carriers, in particular printed circuit boards or integrated circuit substrates. Thus, the jet of processing medium may be configured for dicing a component carrier structure into separate component carriers. By using the jet of processing medium, it may be possible to have a better flexibility to cut the component carrier into different shapes based on a requirement as it may go through different directions by changing the direction of the jet. Thus, the jet beam dicing can go even along a non-straight direction.

In an embodiment, the apparatus is configured for cleaning the surface of the component carrier structure by the processing medium. When a processing medium, for instance comprising a cleaning agent, is directed onto the surface with sufficiently high pressure, a highly efficient cleaning may be achieved.

In an embodiment, the apparatus comprises a reservoir containing said processing medium, in particular processing water, more particularly cleaning water. It is also possible that a plurality of reservoirs are provided, each comprising a different constituent of the processing medium. For instance, a first reservoir may contain a liquid such as water. A second reservoir may contain particles such as sand. Constituents from the first and the second reservoirs may be mixed for forming the processing medium.

In an embodiment, the apparatus comprises a movement mechanism configured for moving the head with respect to the component carrier structure along a predefined trajectory. For instance, a two-dimensional movement mechanism may be provided which allows moving the head in a plane parallel to a main surface of the component carrier structure. Optionally, also the distance between component carrier structure and head may be changed by adding a further movement mechanism allowing for a movement of the head perpendicular to a main surface of the component carrier structure. In an embodiment, the head may be movable in vertical direction by the movement mechanism, but may be fixed in the horizontal plane, and may be arranged over a moving table moving in the horizontal plane. It may also be possible that a table has a vertical axis or additional degree of freedom, such a rotation functionality.

In an embodiment, the apparatus comprises a control unit configured for controlling the head for processing the surface of the component carrier structure by the processing medium in accordance with a predefined processing protocol. For instance, such a control unit may comprise a microprocessor, a central processing unit, etc. which may be programmed for executing a predefined processing protocol (for instance for dicing, cavity formation and/or cleaning the component carrier structure). The control unit may also operate under control of a user and may execute a user command.

In an embodiment, the apparatus comprises a separation unit configured for separating different components of the processing medium. For instance, such a separation unit may be capable of separating one component of the processing medium from other fluidic and/or solid material. This may allow to recycle constituents of the processing medium to reuse them. In an embodiment, the apparatus may comprise a filter and a recycling unit to filter out a valuable component collected by a recycling channel. Then, it may be possible to finally move it to the processing channel for applying it to the component carrier.

In an embodiment, the apparatus comprises at least two heads having the above mentioned features. Thus, the apparatus may operate with a multi-head configuration for parallelizing processing or treatment of the component carrier structure or multiple component carrier structures. This may render the processing highly efficient.

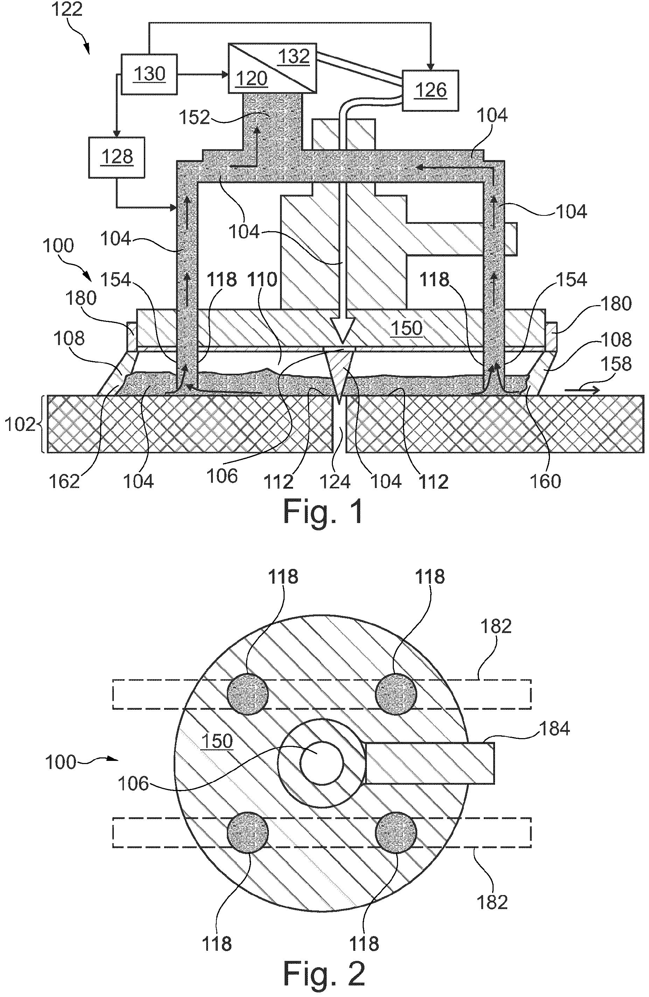

In an embodiment, the apparatus is configured to apply the processing medium to a component carrier structure having a flat surface (as shown in Figure 1). Alternatively, the component carrier structure may have a structured surface facing the head (for example having a cavity or the surface may be structured due to a surface finish and/or solder resist).

In an embodiment, it may be possible to create blind holes instead of through holes by adjusting one or more processing parameters, for example the pressure. Preferably, the depth of the hole can be adjusted when the component carrier structure comprises a material layer withstanding the processing medium. For example, the withstanding material can be an inorganic material such as glass core. Especially the processing medium can modify the property of the inorganic material first and then remove the modified material by adjusting the in line parameters in one process.

In an embodiment, fibers of the peripheral wall may protrude into the formed cavity when moving along the trajectory. This may help to clean the cavity, because the fibers are acting like a broom. Additionally or alternatively, less processing medium can fill the cavity since it is partially filled with fibers. This may simplify to remove the processing medium from the cavity.

In the following, additional features of a component carrier obtained from a component carrier structure processed according to an exemplary embodiment of the invention will be described:
In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB or being plugged in a socket mounted on a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing layer structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component being embedded in and/or surface mounted on the component carrier structure or the component carrier can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of an apparatus for processing a surface of a component carrier structure by a processing medium using a head for exposing the surface of the component carrier structure to the processing medium according to an exemplary embodiment of the invention.
Figure 2 illustrates a top view of the head according to Figure 1.
Figure 3 illustrates a bottom view of the head according to Figure 1.
Figure 4 illustrates a side view of a head for exposing a surface of a component carrier structure to a processing medium according to an exemplary embodiment of the invention.
Figure 5 illustrates a cross-sectional view of an apparatus having a head according to an exemplary embodiment of the invention during moving the head along a component carrier structure.
Figure 6 illustrates a bottom view of a head according to an exemplary embodiment of the invention.
Figure 7 to Figure 10 illustrate surface portions of a component carrier structure treated by an apparatus according to exemplary embodiments of the invention.

The illustrations in the drawings are schematic. In different drawings, similar or identical elements are provided with the same reference signs.

Water jet is a very effective method for cutting a component carrier structure (such as a panel) into individual parts (i.e. component carriers, such as printed circuit boards or integrated circuit substrates). However, there is conventionally an issue with residual water spread in an uncontrolled manner across the parts or the panel.

When using a soft (to avoid scratches) and dense (to effectively restrain water flow) brushes to restrain a water flow, the issue of brushing the surface of the parts may occur which may generate electrostatic charge on the surface of the parts when cutting parts from panels.

Also component carriers (in particular substrates) with one or more embedded components (such as semiconductor chips) may be singulated by water jetting. However, this may involve electrostatic discharge (ESD) issues. Thus, cavity cutting and other tasks with such kind of component carriers would have to be executed without affecting the embedded components.

According to an exemplary embodiment of the invention, a head for an apparatus for exposing and processing a surface of a component carrier structure (like a PCB panel) by a processing medium (for example a mixture of a fluid, such as water, with particles, such as sand, which may be provided at elevated pressure) may be provided. For example, such a head and assigned apparatus may be used for dicing a component carrier panel into individual component carriers (such as PCBs or IC substrates). At least one ejection opening (like an ejection nozzle) may be provided at the head for ejecting the processing medium to hit the surface of the component carrier structure for impacting (for instance for cutting or cleaning) the latter in a defined way. A peripheral wall of the head, which may be for instance circumferentially closed, together with a dedicated portion of the component carrier structure may enclose a working space containing processing medium. An undesired outflow of the processing medium out of said working space, when the head is in its working position directly on or close to the component carrier structure, may be inhibited. This may ensure that at least the vast majority of the processing medium ejected by the at least one ejection opening into the working space does not flow out of the working space so as to prevent undesired contamination of unwanted structures with the processing medium. Furthermore, a processing medium outlet of the head may ensure discharging processing medium out of the working space, for instance by actively or passively sucking processing fluid away from the working space through the head. This may enable a controlled handling of the processing medium and a continuous supply of processing medium to the component carrier structure to be processed without the risk of overflow or contamination caused by processing medium. Hence, a component carrier structure surface treatment may be executed with precise control, reliability, reproducibility and without a noteworthy risk of failure. Meanwhile, the direction of processing medium ejected from the head can be accurately controlled, so the processing medium can move along with the predefined routine by the control unit until the processing medium goes through the material in a fast speed. This may be beneficial for cutting or singulation for panels in an efficient manner.

In particular, exemplary embodiments of the invention may allow to use water jetting in an ESD safe manner by removing electric charges created during water jetting by electrically conductive structures (such as one or more electrically conductive fibers) of a peripheral wall of a head of an apparatus for processing the component carriers by a processing medium. The use of conductive fibers may avoid the formation of electrical charges on the surface of dielectrics when undergoing friction. Said phenomena can be called triboelectric effect that would occur when friction between dielectric surfaces produces patterns of fixed, stable electric charges. Hence, exemplary embodiments may provide an improved water jet cutting head being appropriate also for cutting ESD-sensitive component carriers, such as IC substrates, in particular when one or more ESD-sensitive electronic components (such as a semiconductor die) is embedded in the corresponding component carriers. In particular, a brush of the peripheral wall of the head may be configured to restrain the processing medium (in particular water) flow and an abrasive spreading on the component carrier structure. At the same time, such a peripheral wall brush may be configured as an ESD safe element capable of contributing to the removal of electrically conductive charges created on the component carrier structure during processing by the processing medium. In particular, such a peripheral wall brush may be equipped with electrically conductive fibers (such as carbon fibers) which may, for instance, be connected to a discharging electronic circuit of the head or apparatus for ensuring ESD compatibility. This may allow to reliably avoid the creation of electrostatic charging of the parts (such as PCBs or IC substrates) of the component carrier structure. For instance, exposed material of the substrates may comprise epoxy material in the form of a solder mask, a resin sheet and/or FR4 (i.e. resin, such as epoxy resin, with reinforcing particles, such as glass fibers). Such ESD protection may be of utmost advantage when cutting parts of a component carrier structure with already embedded devices (such as semiconductor chips), and/or or cutting cavities (for example to host one or more active components). Advantageously, the peripheral wall of the head may be realized using a fiber brush being ESD safe to avoid electrostatic charging and/or to remove electrostatic charges of the surface of the component carrier structure due to the movement of the brush or the head on a part of the component carrier structure. Preferably, the construction of a containment may include the formation of a static dissipative brush that has the capability of containing the spread of the processing medium (such as water and/or sand) after the cutting. Beneficially, a static dissipative circuit may be provided to avoid electrostatic charging of the component carrier structure (such as a panel) or parts thereof. In particular, cutting using pressurized processing medium can also be executed at a later stage of a manufacturing process.

For example, the cutting of component carrier structures with electronics may involve the use of deionized and/or demineralized water, which intrinsically is not electrically conductive and not necessarily capable to prevent ESD issues. Moreover, the use of water jetting with abrasive material (such as sand) as processing medium to cut a component carrier structure into individual component carriers (such as PCBs and/or IC substrates) and/or for forming cavities in a component carrier structure (for instance for embedding electronic components therein) may involve the controlling of a corresponding surface area of the component carrier structure in contact with the processing medium (in particular water and sand) as residue of the cutting operation. In order to tackle such challenges, exemplary embodiments may configure a peripheral wall of the head so as to cooperate with the component carrier structure to contain processing medium in a spatially confined region to avoid uncontrolled spreading of the processing medium. This may be achieved by maintaining processing medium (such as water) to remain, after cutting, in a working space by the use of a fibers brush as peripheral wall of the head.

According to exemplary embodiments, removal of used processing medium (such as wastewater) may be accomplished by discharging said processing medium through at least one processing medium outlet of the head. In particular, this may be realized through one or more Bernoulli effect pumps within the head area. Advantageously, this may ensure that no waste affects critical regions of the head (such as a suction circuit), apparatus or component carrier structure. In an embodiment, processing medium (in particular water) residues may be removed from the surface of the component carrier structure within an area covered by the head. Preferably, this may be accomplished with a Bernoulli principle extraction, or a suction pump.

For realizing the peripheral wall of the head, it may be possible to use a brush of carbon fibers. For instance, said carbon fibers may have a diameter in a range from 1 µm to 10 µm (in particular in a range from 6 µm to 7 µm). For instance, a length of the carbon fibers may be in a range from 5 mm to 50 mm (in particular in a range from 9 mm to 18 mm). For instance, a density of 60000 filaments/cm±50000 filaments/cm may be used. Said filaments or fibers may be bundled to form a brush compatible to the head, for instance to comply with requirements of water jetting. Additionally or alternatively, the brush of carbon fibers may comprise a hardness configured for gently treating, in particular not damaging, the surface of the component carrier structure.

Advantageously, a head according to an exemplary embodiment may ensure an ESD safe operation using water jet technology for cutting a component carrier structure into parts even when the latter are equipped with embedded ESD sensitive components. Advantageously, water jetting may be faster for opening cavities for embedding or for forming through holes compared to laser processing or the like.

According to an exemplary embodiment, the head and apparatus may be used for routing of cavities and singulation of parts with embedded (in particular active) components using water jetting. A head and apparatus according to exemplary embodiments may be configured to maintain control on the cleanliness of the parts. Moreover, exemplary embodiments may offer the opportunity to achieve a limited spreading of used water running on a surface of parts of the component carrier structure. An ESD dissipative functionality of the head, more specifically its peripheral wall, may allow to avoid the build-up of electrostatic charge on the parts.

Exemplary applications of exemplary embodiments of the invention relate to the manufacture (for instance singulation) and/or the maintenance (for example cleaning) of component carriers with one or more cavities, in particular for component embedding. Moreover, exemplary applications of exemplary embodiments may involve processing of component carrier structures (such as IC substrates and PCBs) using water jetting for singulation. One application of exemplary embodiments is to open cavities into cores, which would be beneficial in terms of cleanliness. A further application of exemplary embodiments may relate to the routing of parts of a component carrier structure with embedded components, which may benefit from the avoidance of generating electrostatic charge on the surface of the parts. Thus, a highly reliable ESD protection may be provided by exemplary embodiments.

According to an exemplary embodiment of the invention, a head suitable to hit a surface of a component carrier with a processing liquid (or more generally a fluid, preferably a liquid, wherein the fluid may optionally comprise in addition solid particles; for example, the fluid may be water and the particles may be silicon oxide, or the fluid may be air and the particles may be dry ice) is provided, wherein the head may comprise at least one processing liquid ejecting opening or nozzle, a peripheral wall delimiting a holding space to contain the ejected processing liquid when the head is in its working position with respect to the surface to be hit by the processing liquid, and a processing liquid outlet configured to discharge the ejected processing liquid from the holding space.

In an embodiment, the head further comprises an electrostatic discharge (ESD) element configured to discharge electrostatic charge from the surface to be hit by the processing liquid. For instance, the ejection opening or nozzle may be configured to eject the processing liquid in a jet-beam form. In particular, the opening or nozzle may be configured to eject the processing liquid with a high pressure. In an example, the jet-beam may be ejected with a high pressure for example at least 1000 bar. In another example, the jet-beam may be ejected with a high pressure for example in the range from 100 bar to 3500 bar. Still in a further example, the jet-beam may have an extension, for example a radius, in the range from 50 µm to 5 mm, in particular from 150 µm to 750 µm. For instance, openings of the nozzles can be for example 200 µm for water jet with no abrasive, and for instance 300 µm when abrasive is used. In an embodiment, the elements of the head delimiting the holding space have surface features suitable to prevent the collection of particles-scraps (in particular of component carrier materials such as resin, conductive material, fillers, inorganic insulating material such as glass, etc.) in the holding space. For example, surface tension, fluid dynamic setting of the discharging processing liquid, etc., may be considered.

The peripheral wall of the head may define a closed profile, so that the peripheral wall together with other head elements and the surface to be hit by the processing liquid may form a closed volume (preferably in a tight manner apart from the outlet). It may be possible that the peripheral wall is a not homogeneous structure. For instance, the peripheral wall may comprise fibers, preferably electrically conductive fibers such as carbon fibers. In an embodiment, the peripheral wall may have a brush shape. At least one fiber of the peripheral wall may act as ESD discharge element. For this purpose, one, some or all fibers may be made of an electrically conductive material and/or may be electrically grounded. Different fibers may be spaced with respect to each other and/or may be provided with a surface energy and/or may be covered with a liquid (such as a liquid film) imparting a surface tension to hold the processing liquid inside the holding space. For instance, fibers may have a diameter in a range from 5 µm to 10 µm and/or may have a length in a range from 5 mm to 20 mm. Alternatively, the fibers may have a diameter in a range from 10 µm to 50 µm and/or may have a length in a range from 500 µm to 5 cm. For example, a fiber or filament density may be 60000 filaments or fibers/cm. For instance, the peripheral wall (and in particular its fibers) may form an inhomogeneous wall. The peripheral wall, and in particular its fibers, may form a deformable and/or elastic wall. Optionally, the peripheral wall, in particular at least a part of the peripheral wall, may comprise a lip, for instance comprising deformable and/or elastic material, for example rubber. In an embodiment, the peripheral wall may be a porous wall. Such a porous wall may have closed pores and/or opened pores (in particular the latter with a pore dimension-void/wall material to hold the processing liquid inside the holding space). For example, at least one electrically conductive element in and/or on the deformable wall may act as ESD discharge element. Preferably, the peripheral wall is configured to contact the surface to be hit when the head is in its working position. The peripheral wall may be configured to hold the processing liquid even when sliding the head along a direction parallel to the surface to be hit.

Concerning the at least one processing liquid outlet or processing medium outlet, it may comprise an outlet section connected to the holding space for the flowing of the exiting processing fluid. For example, several outlets may be provided which may be connected to the holding space. In particular, an outlet exposed to the holding space may have a structured shape. This may be supported or promoted by the fact that the holding space may be full of liquid, due to the peripheral wall. In particular, the at least one processing medium outlet may have an elongated, circumferential and/or concentric shape. In an embodiment, the outlet protrudes inside the holding space (in particular to be close to the hit surface, to promote the suction of all liquid). In an embodiment, the outlet may be connected to a suction device. Such a suction device may be configured to create a suction force (for example through a Bernoulli effect or by a Venturi pipe) at the outlet, in particular triggered by the flow of the processing liquid entering in the holding space. In an embodiment, the suction device may be a suction pump. Such a section device or suction pump may be provided with a sucking capability. In an example, the flow of the ejected processing medium may be the same as the flow of the discharged processing medium. In another example, the flow of the ejected processing medium may be different, in particular smaller, than the flow of the discharged processing medium. When the holding space is full of liquid, this may be promoted or supported due to the peripheral wall. The processing medium outlet and/or the suction device may be configured for handling and a mixture of processing liquid and solid particles and/or scraps of component carrier materials (such as resin, conductive material, fillers, inorganic insulating material such as glass, etc.). In an embodiment, the outlet is associated to the peripheral wall so that the processing liquid passes through said peripheral (in particular porous and/or fibrous) wall to pass through the outlet. For example, the peripheral wall is detached from the surface to be hit when the head is in its working position. In an embodiment, the distance between the peripheral wall and the surface to be hit is such that due to the viscosity and/or surface tension of the processing liquid, a passage between the peripheral wall and hit surface is prevented.

Moreover, an exemplary embodiment provides an apparatus comprising the above mentioned head. Such an apparatus may be configured for cleaning the surface of the component carrier hit by the processing medium, such as processing water. In embodiments, the processing water may be a cleaning water. However, the apparatus may also be configured for cavity formation and/or through hole formation in the component carrier structure. It is also possible that the apparatus is configured for dicing or singularization of the component carrier structure into individual component carriers (such as printed circuit boards and/or integrated circuit substrate). Preferably, after the formation of the cavity and/or through hole and/or after singularization of the component carrier structure into individual component carriers a cleaning process of the apparatus may be performed. This may provide more flexibility concerning cutting direction control which may allow to perform different kinds of cutting by using one machine.

According to an exemplary embodiment of the invention, a head and an apparatus for processing a component carrier structure with a processing medium are provided. A peripheral wall, which may comprise brushes (preferably made of fibers) may contribute to keep processing medium in a containment formed by the head and the component carrier structure. Used processing medium in said containment may be discharged via a processing medium outlet. Advantageously, the head may provide an electrostatic discharge protection for removing electrical charge carriers created during processing the component carrier structure with the processing medium. Preferably, such an ESD protection may be provided by an electrically conductive peripheral wall, in particular comprising electrically conductive fibers. This may protect the component carrier structure and individual component carriers thereof, in particular when the latter are provided with ESD sensitive electronic components (such as embedded semiconductor chips). Without wishing to be bound to a specific theory, it is presently believed that the mentioned electric charge is created by friction between the processing medium and the component carrier structure. Alternatively, electric or electrostatic charges may be generated during previous process stages and may be located on the surface of the component carrier structure. Electrically conductive brushes of the peripheral wall in physical contact with the component carrier structure may remove at least part of said electric charges from the component carrier structure, thereby providing an ESD protection. Thus, surface charge may be removed away from the component carrier structure.

More specifically, a component carrier structure (for instance comprising printed circuit boards and/or integrated circuit substrates) may be cut by a mixture of water and sand in a containment to avoid spreading of said processing medium. In an example, the processing liquid provided by the ejection opening may be provided in a direction perpendicular (or slanted) to the main surface of the head. In another example, the processing liquid provided by the ejection opening may be provided in a direction perpendicular (or slanted) to the main surface of the component carrier structure. During processing, water and sand may remain inside said containment. The containment may be configured to avoid scratching of the surface of the component carrier structure while removing used processing liquid and electric charge generated by said processing. Advantageously, a peripheral wall configured as a brush ring may avoid scratching by being provided with flexible or elastic properties. Advantageously, the brush may be made of an electrically conductive material for additionally removing electric charges from the component carrier structure (such as a panel). Further advantageously, it may be possible to move the head with its fiber ring along a surface of the component carrier structure during processing the latter. For instance, this may allow cutting the component carrier structure along a trajectory, for instance for separating individual component carriers of the component carrier structure. During this process, the moving fiber ring of the peripheral wall may provide continuously an ESD protection by removing electric charges created during the described process. In order to accomplish this, fibers of the peripheral volume may be provided as elastic, dense and electrically conductive structures. During ensuring an ESD protection, used processing medium may be discharged from the working space, for instance by sucking it off. This may prevent undesired accumulation of processing liquid on and around the component carrier structure. The described process is compatible even with surface mounted components on the component carrier structure due to the elasticity and deformability of the fibers of the peripheral wall. In an embodiment, the apparatus is configured for processing a component carrier structure having a thickness in a range between 30 µm to 3 cm. In particular, the technical capability of the technology can go well above 3 cm, for example for cutting of stacks of boards, such as a stack of 2 to 5 boards (like IC substrates or PCBs).

Exemplary embodiments may reduce surface contamination of wastewater delivering an ESD safe operation for carriers, which may optionally carry embedded and/or surface mounted functional components. Furthermore, exemplary embodiments may limit the spreading of wastewater on parts of the component carrier structure. Advantageously, very quick and reliable processing of the component carrier structure is possible according to exemplary embodiments. In particular, the cutting speed with processing medium under pressure may be significantly faster than with laser cutting (for instance for forming cavities for accommodating electronic components). Moreover, cutting with a pressurized processing medium according to exemplary embodiments of the invention may provide better quality than mechanical routing (for separating printed circuit boards).

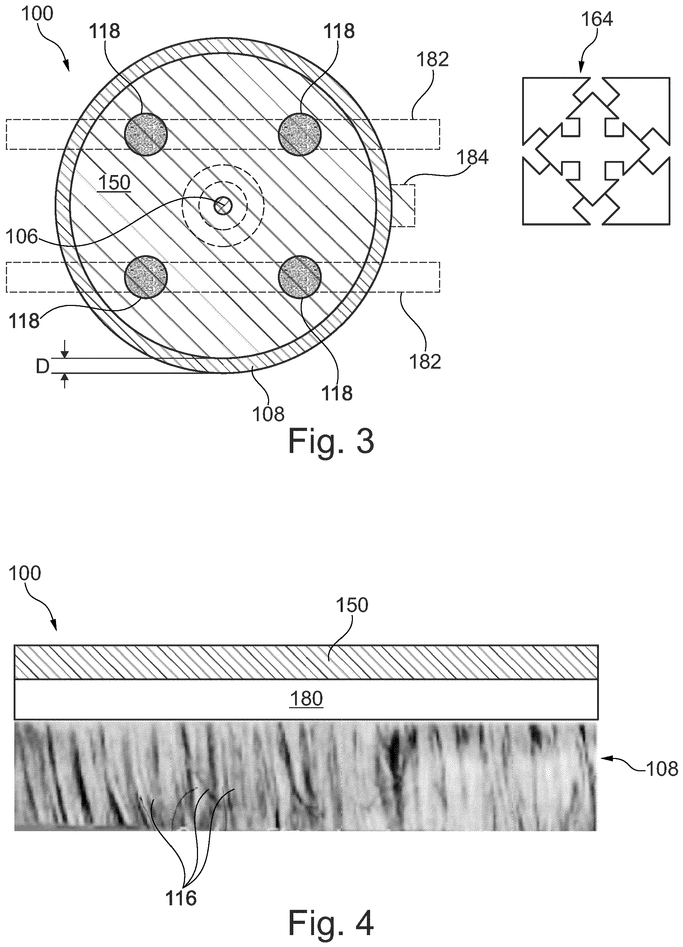

**Figure 1** illustrates a cross-sectional view of an apparatus 122 for processing a surface 112 of a component carrier structure 102, as a specimen under water processing, by a processing medium 104 using a head 100 for exposing the surface 112 of the component carrier structure 102 to the processing medium 104 according to an exemplary embodiment of the invention. **Figure 2** illustrates a top view of the head 100 according to Figure 1. **Figure 3** illustrates a bottom view of the head 100 according to Figure 1. In the shown embodiment, the component carrier structure 102 may be a panel comprising a plurality of still integrally connected component carriers, such as printed circuit boards or integrated circuit substrates. In this embodiment, the processing may be a separation of the component carrier structure 102 into the individual component carriers by cutting through the component carrier structure 102 along rows and columns. For this purpose, processing medium 104 in form of a mixture of water and sand may be used which is directed onto the surface 112 of the component carrier structure 102 as a laterally confined jet with a high pressure of for example 3000 bar. Due to the high pressure and/or the composition of the processing medium 104, the processing medium may have an abrasive effect (on the surface of the component carrier structure 102).

The head 100 is configured for exposing the surface 112 of the component carrier structure 102 to a treatment with the processing medium 104. For this purpose, the head 100 comprises an ejection opening 106, for instance functioning as a water inlet, for ejecting the processing medium 104 onto the surface 112. Referring to Figure 2 and Figure 3, the ejection opening 106 may be fluidically connected with an inlet conduit 184 (which may for instance be a two-part body). In the shown embodiment, the ejection opening 106 is configured as a nozzle. Preferably, the nozzle shall be arranged at a vertical level for preventing scratching of the component carrier structure 102 by said nozzle-type ejection opening 106. Although only a single ejection opening 106 is shown in Figure 1, a plurality of ejection openings 106 are possible as well in another embodiment. The processing medium 104 is supplied to the ejection opening 106 from a reservoir 126 with high pressure of for example at least 1000 bar. A pressurizing unit (not shown) may pressurize processing medium 104 from reservoir 126 for ejection through ejection opening 106. Thus, the ejection opening 106 may be configured to eject the processing medium 104 as a jet-beam. More specifically, nozzle-type ejection opening 106 may be configured to eject the processing medium 104 onto the component carrier structure 102 with a high pressure of preferably at least 1000 bar, for instance 3000 bar.

The head 100 may comprise a base body 150, such as a horizontal plate, from which a peripheral wall 108 extends downwardly. For instance, peripheral wall 108 may be a circumferentially closed annular structure. The peripheral wall 108 together with the base body 150 (from a top side according to Figure 1) and a portion of the component carrier structure 102 (from the bottom side according to Figure 1) may together delimit a working space 110 into which the processing medium 104 is ejected via ejection opening 106 extending through base body 150. When the head 100 is in its working position as shown in Figure 1, in which the head 100 faces the component carrier structure 102 preferably with direct physical contact between the upper main surface 112 of the component carrier structure 102 and the bottom surface of the peripheral wall 108, ejected processing medium 104 may remain (for instance partially) inside the working space 110. Another part of the processing medium 104 may also flow vertically through component carrier structure 102, for instance when a through hole 124 is formed by the water-sand jet. Thus, the peripheral wall 108 may be configured to contact the surface 112 to be exposed to the processing medium 104 when the head 100 is in its working position.

In another embodiment (not shown), there may be a small vertical gap between the component carrier structure 102 and the bottom of the peripheral wall 108 in the working position of the head 100. Thus, the peripheral wall 108 may be spaced from the surface 112 to be exposed to the processing medium 104 by a distance when the head 100 is in its working position. Said gap may be so small that no or substantially no processing medium 104 will escape from the working space 110 laterally through the gap. Descriptively speaking, the distance between the peripheral wall 108 and the surface 112 to be exposed to the processing medium 104 may be so small and the gap may be so tiny that due to the viscosity of the processing medium 104 a medium passage between the peripheral wall 108 and the surface 112 to be exposed to the processing medium 104 is prevented.

Preferably, the peripheral wall 108 is circumferentially closed so as to form a closed ring structure, as shown in Figure 3. As a result, the head 100 and the surface 112 to be exposed to the processing medium 104 may form a closed volume which may reliably prevent processing medium 104 from escaping laterally. This reliability may be further enhanced when the peripheral wall 108 is made of a deformable material, preferably an elastically deformable material. For instance, this may be accomplished by making the peripheral wall 108 of a porous material, in particular having closed pores and/or open pores. The porosity of the peripheral wall 108 may provide the elastically deformable properties thereof.

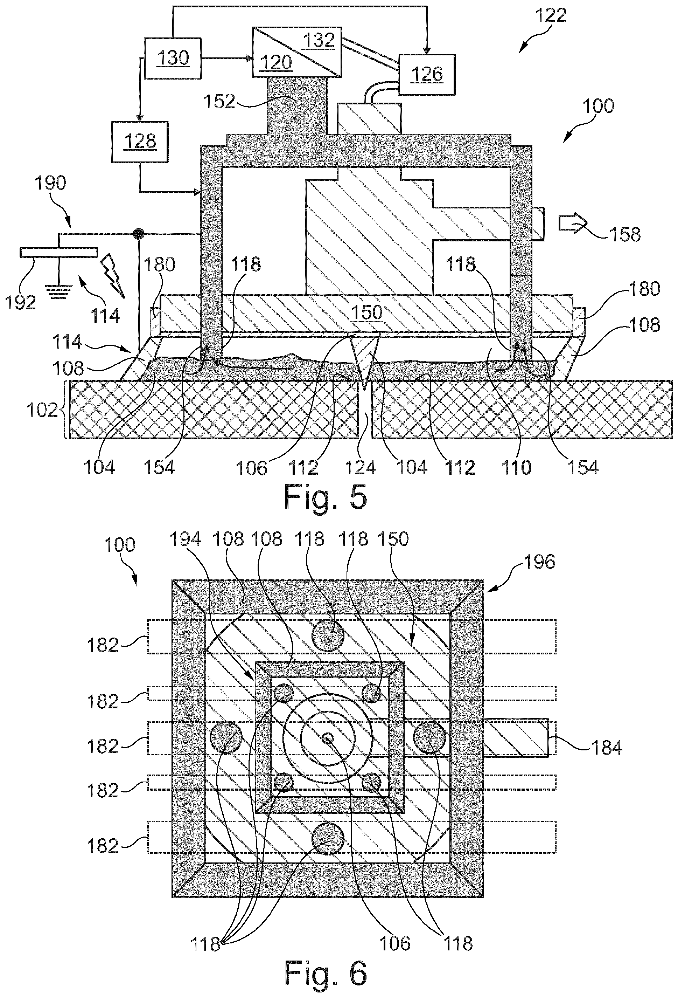

However, it may be even more preferred when the peripheral wall 108 comprises a bundle of fibers (see reference sign 116 in Figure 4). The fiber bundle may be connected to a fiber holder 180 which may be connected, in turn, to base body 150 of head 100. For example, fiber holder 180 can be separated in a plurality of (in particular in three) pieces, so that the fibers 116 can be mounted in front and/or behind the cross sectional plane of the illustration. Such a bundle of fibers may be elastically deformable, may efficiently inhibit outflow of processing medium 104 out of working chamber 110 and may also provide an electrostatic discharge (ESD) protection by removing at least part of electric charge which may be generated for instance by friction between head 100, processing medium 104 and the component carrier structure 102 during processing. This will be explained in detail referring to Figure 4 and Figure 5.

Further advantageously, the peripheral wall 108 may also be configured to maintain the processing medium 104 in the working space 110 even when moving the head 100 along the surface 112 to be exposed to the processing medium 104. Such a scenario is shown in Figure 1 in which the head 100, during processing the component carrier structure 102 (for instance for forming elongate through holes 124) moves along a direction 158. Due to the elastic deformability of the peripheral wall 108, a leading edge 160 of the peripheral wall 108 may be bent inwardly, whereas a trailing edge 162 of the peripheral wall 108 may be bent outwardly in a reversible fashion while maintaining continuously a processing medium sealing function. When the motion is stopped, the elastically deformable peripheral wall 108 may return into its straight or vertical orientation. Advantageously, the described configuration of the peripheral wall 108 may therefore maintain its leakage-tight properties even during motion of the head 100 along the upper main surface 112 of the component carrier structure 102 for processing the latter along any defined trajectory.

As shown as well in Figure 1 to Figure 3, head 100 comprises a plurality of a processing medium outlets 118, for instance functioning as a water outlet, each configured to discharge ejected processing medium 104 from the working space 110 towards a waste or recycling reservoir (not shown). Referring to Figure 2 and Figure 3, the processing medium outlets 118 may be fluidically connected with one or more outlet conduits 182. As best seen in Figure 2 and Figure 3, the processing medium outlets 118 may be arranged in a regular pattern (for instance on the corners of a square according to the described embodiment) so as to be homogeneously distributed over the spatial extension of the working space 110. In the shown embodiment, four processing medium outlets 118 are foreseen. Other arrangements and numbers of processing medium outlets 118 are possible. As indicated by arrows in Figure 1, processing medium 104 in working space 110 may flow laterally along the portion of the surface 112 of the component carrier structure delimiting the working space 110 and from there upwardly into the various processing medium outlets 118. As shown, each of the processing medium outlets 118 comprises an outlet section which is in direct fluid communication with the working space 110 for draining the processing medium 104. For efficiently discharging processing medium 104 from working space 110, the processing medium outlets 118 may form a bifurcated network of flow channels by which processing medium 104 flowing through the various processing medium outlets 118 flows together at a rejoining position 152. This fluidic network allows to provide only a single suction device 120, connected to all processing medium outlets 118, for sucking the processing medium 104 out of the working space 110. Again referring to Figure 1, each processing medium outlet 118 may protrude, with a respective protruding section 154, into an inside of the working space 110. This may improve the efficiency of the removal of processing medium 104 out of the working space 110. As shown, each protruding section 154 may extend deeper into the working space 110 than the bottom main surface of the base body 150. In an example, the protruding section 154 may extend deeper into the working space 110 than the ejection opening 106, for example a nozzle. For instance, protruding section 154 can be formed as a tube. In another example, the protruding section 154 may extend to the same vertical level into the working space 110 as the ejection opening 106, for example a nozzle.

Advantageously, the suction device 120 may be configured to create a suction force at the processing medium outlets 118. For example, this may be triggered by a flow of the processing medium 104 entering in the working space 110. It may also be possible that the suction device 120 comprises one or more suction pumps actively drawing processing medium 104 out of the working space 110. Advantageously, the suction device 120 may be provided with a sucking capability for processing medium 104 comprising water, sand and scraps of the component carrier structure 102 created when forming one or more through holes 124 in component carrier structure 102 by a pressurized jet of water and sand.

A delimiting structure, to which peripheral wall 108 and body 150 may belong, of the head 100 delimiting the working space 110 may have a surface structure (for instance non-adhesive) configured for preventing collection of particles and/or scraps of the processed component carrier structure 102 in the working space 110. When forming through holes 124 in component carrier structure 102 by the pressurized processing medium 104 ejected through the nozzle-type ejection opening 106, particles, scraps, etc. of component carrier material may be created in working space 110. By appropriately adapting the surface properties of the head 100 delimiting the working space 110, undesired adhesion of such particles or scraps at the head 100 may be prevented.

Next, further advantageous features of the apparatus 122 operating the head 100 according to Figure 1 to Figure 3 will be explained.

Advantageously, the apparatus 122 may comprise a control unit 130 configured for controlling the head 100 for processing the surface 112 of the component carrier structure 102 by the processing medium 104 in accordance with a predefined processing protocol. The control unit 130 may for instance comprise a processor configured for executing instructions in accordance with said predefined processing protocol. For example, the processing protocol may be defined by a user or by a software executed by control unit 130. It may also be possible that the processing protocol is hard-wired by corresponding electric circuitry. In an embodiment, a user interface (not shown) may be provided by which a user may provide commands to the control unit 130 concerning operation of apparatus 122 and/or by which operation data of the apparatus 122 may be displayed to a user.

In particular, the processing protocol may define how the component carrier structure 102 shall be processed by apparatus 122. For instance, the apparatus 122 may be configured for removing material of the component carrier structure 102 by the processing medium 104 for forming through holes 124 in component carrier structure 102 in accordance with the processing protocol. For example, said processing protocol may define trajectories along which a jet of processing medium 104 may be exposed to the component carrier structure 102 for separating the latter into a plurality of separated component carriers, such as PCBs or IC substrates. In other words, the apparatus 122 may be configured for singularizing the component carrier structure 102 into a plurality of individual component carriers by the jet of processing medium 104, and then it may be able to clean it in one machine after cutting.

Alternatively, a processing protocol executed by control unit 130 of the apparatus 122 may be configured for forming one or more cavities in the component carrier structure 102 by the processing medium 104. For instance, at least one cavity may be formed per component carrier of the component carrier structure 102. For example, a respective cavity may be used for embedding an electronic component therein, for instance a semiconductor chip.

In yet another application, a processing protocol executed by control unit 130 of the apparatus 122 may be configured for cleaning the surface 112 of the component carrier structure 102 by the processing medium 104. Also for cleaning purposes, a surface 112 or surface portion of the component carrier structure 110 may be scanned by the jet of processing medium 104. Preferably, for cleaning the pressure of the processing medium 104 and/or the radius of the jet-beam may be adjusted in order to achieve good cleanness on the surface of the component carrier structure 102.

As shown as well in Figure 1, the apparatus 122 may comprise a reservoir 126 containing said processing medium 104. Said reservoir 126 may be in fluid communication with the ejection opening 106 for ejecting processing medium 104 into working chamber 110 and from there towards a target position on component carrier structure 102. For instance, said reservoir 126 may be filled with a mixture of water and sand or cleaning water, depending on a specific application or processing task. It may also be possible to provide a plurality of reservoirs 126, for instance one for water and another one for sand. By mixing individual constituents of the processing medium 104, any desired composition may be created.

Moreover, the apparatus 122 comprises a movement mechanism 128 configured for moving the head 100 with respect to the component carrier structure 102 along a predefined trajectory. The movement mechanism 128 may be configured for scanning a two-dimensional surface area of the upper main surface 112 of component carrier structure 102 by processing medium 104. Reference sign 164 in Figure 3 illustrates moving directions of head 100 during ejecting processing medium 104.

As illustrated schematically in Figure 1, the apparatus 122 may also comprise a separation unit 132 configured for separating different components of the discharged processing medium 104. Such a separation may comprise a physical separation and/or a chemical separation. By said separation, different constituents of the sucked off processing medium 104 may be separated, for instance a processing fluid (such as water) may be separated from solid processing particles (such as sand), and contaminants (for instance scrap of component carrier structure 102) may be separated as well. The separated processing fluid and/or the separated processing particles, for example the sand, may be recycled and forwarded to at least one reservoir 126.

Although not shown in the figures, the apparatus 122 may also comprise two or more heads 100, which may for instance be constructed as shown in Figure 1 to Figure 3. For instance, this may allow to parallelize processing of component carrier structure 102 by processing different surface portions of component carrier structure 102 by different heads 100 and different jets of processing medium 104 simultaneously. It may also be possible to process different component carrier structures 102 with different heads 100 of the same apparatus 122 (for instance under control of a common control unit 130) in parallel. This may further improve the efficiency of the processing.

**Figure 4** illustrates a side view of a head 100 for exposing a surface 112 of a component carrier structure 102 to a processing medium 104 according to an exemplary embodiment of the invention. More specifically, Figure 4 shows a brush formed by a bundle of fibers 116 for constituting the peripheral wall 108. As shown, the fibers 116 are connected to fiber holder 180 being connected, in turn, to base body 150 of head 100. Preferably, said fibers 116 are arranged or grouped as a brush to form a fiber brush. A radial extension, D, of the fiber brush is shown in Figure 3.

Advantageously, the peripheral wall 108 may be partially or entirely formed of electrically conductive fibers 116, such as carbon fibers. A correspondingly obtained electrically conductive fiber brush may function advantageously to dissipate electric charges on ungrounded parts of component carrier structure 102. Friction between peripheral wall 108, processing medium 104 and component carrier structure 102 may create such charges on surface 112 of component carrier structure 102 during operation of apparatus 122. When electrically conductive fibers 116 are in direct physical contact with surface 112 of component carrier structure 102, the electrically conductive fibers 116 may dissipate said electric charges and may therefore provide an electrostatic discharge (ESD) functionality to the component carrier structure 102. This may avoid electric damage of the component carrier structure 102. For instance, the electric charges may be removed from the component carrier structure 102 via the electrically conductive fibers 116 towards ground or another reference potential. When component carrier structure 102 or individual component carriers thereof are to be tested through a grounding/discharging circuit, the latter may contribute to the charge removal. Although electrically conductive fibers 116 may be a preferred embodiment for forming peripheral wall 108, peripheral wall 108 may also be realized with other electrically conductive structures (for instance an electrically conductive porous structure having elastic properties) for obtaining an ESD protection function.

However, electrically conductive fibers 116 are of utmost advantage for forming head 100. Apart from providing an ESD protection, electrically conductive fibers 116 (for instance carbon fibers) are also elastically deformable so that they maintain a fluid tight interface to the component carrier structure 102 even when head 100 is moved along component carrier structure 102. Furthermore, an electrically conductive fiber bundle may be dense enough to prevent processing medium 104 from flowing through the fiber bundle out of working space 110.

For instance, the fibers 116 of Figure 4 may be carbon fibers with a diameter of for example 6 µm to 7 µm, a length in a range from 9 mm to 18 mm and a density of 10000-100000 fibers per centimeter length of the peripheral wall 108. An entire circumferential length of the peripheral wall 108 may be for instance in a range from 50 mm to 500 mm, for example 150 mm. Thickness, D, of peripheral wall 108 embodied as fiber bundle may be for example in a range from 1 mm to 10 mm, for instance 5 mm.

**Figure 5** illustrates a cross-sectional view of an apparatus 122 having a head 100 according to an exemplary embodiment of the invention during moving the head 100 along a component carrier structure 102.

The embodiment of Figure 5 corresponds to the embodiment of Figure 1, but additionally shows elements of an electrostatic discharge unit 114. Beneficially, head 100 may comprise the electrostatic discharge unit 114 for providing an electrostatic discharge (ESD) protection to the component carrier structure 102. The electrostatic discharge unit 114 of Figure 5 is configured to remove at least part of electrostatic charge from the surface 112 of the component carrier structure 102 to be exposed to the processing medium 104. Generally, at least one separate electrically conductive element and/or the peripheral wall 108 may be configured as at least part of the electrostatic discharge unit 114. In an example, the electrically conductive element and/or the peripheral wall 108 and/or the electrically conductive fiber 116 may comprise a material having an electrical conductivity higher than 10² S/m, in particular higher than 10⁴ S/m. In a preferred embodiment, electrically conductive fibers 116, such as carbon fibers, may form at least part of the peripheral wall 108 and may thus be configured to constitute at least part of the electrostatic discharge unit 114.

Also referring to Figure 4 and corresponding description, an electrically conductive fiber bundle constituting peripheral wall 108 functioning as electrostatic discharge unit 114 may be a preferred choice. Such a configuration may provide a reliable ESD protection, may be elastically deformable so as to support motion of head 100, and may prevent processing medium 104 from laterally leaving working space 110.

Still referring to Figure 5, the peripheral wall 108 with ESD protection (in particular provided by an electrically conductive fiber bundle forming the peripheral wall 108 or part thereof) may be electrically connected within an ESD grounding circuit 190. For instance, ESD grounding circuit 190 may connect the peripheral wall 108 to an electric reference potential 192, for instance ground potential. Optionally, the ESD grounding circuit 190 may also connect one or more other portions of head 100 to the electric reference potential 192 (in particular ground)

**Figure 6** illustrates a bottom view of a head 100 according to an exemplary embodiment of the invention. More specifically, Figure 6 shows a structured head 100. In the embodiment of Figure 6, the peripheral wall 108 is composed of separate structures. An interior portion 194 of the peripheral wall 108 has a rectangular shape. An exterior portion 196 of the peripheral wall 108 has a rectangular shape. The exterior portion 196 circumferentially surrounds the interior portion 194. Such a geometry may lead to excellent properties in terms of inhibition of flow of processing medium 104 out of the working space 110. Each of the interior portion 194 and the exterior portion 196 may be composed of four parts connected to one circumferentially closed structure (in particular during movement of the head 100). In an example, a plurality of processing medium outlets 118 may be located such, that the respective processing medium outlet 118 is located between the ejection opening 106 and the interior portion 194 of the peripheral wall 108 in a top view. In another example, a plurality of processing medium outlets 118 may be located such that the respective processing medium outlet 118 is located between the interior portion 194 of the peripheral wall 108 and the exterior portion 196 of the peripheral wall. The processing medium outlet 118 located between the ejection opening 106 and the interior portion 194 of the peripheral wall 108 and the ejection opening 106 and the processing medium outlet 118 located between the interior portion 194 of the peripheral wall 108 and the exterior portion 196 of the peripheral wall may have different size and/or shape.

In an embodiment, the head 100 has a circular shape. Another embodiment, the head 100 may have any other shape, for instance a polygonal shape. For example, the fibers 116 can be provided spaced with respect to the outer circumference.

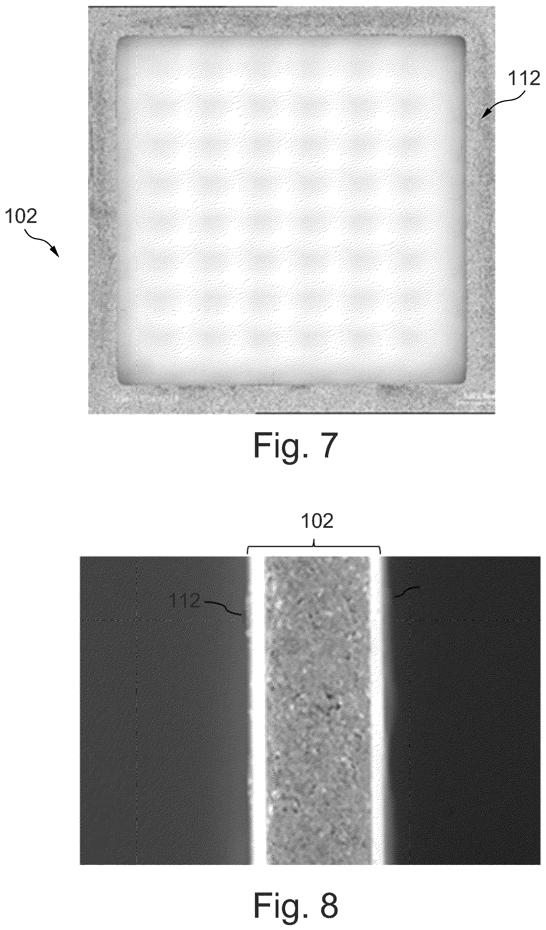

**Figures 7 to Figure 10** illustrate surface portions of a component carrier structure 102 treated by an apparatus 122 according to exemplary embodiments of the invention. More precisely, to Figure 7 to Figure 10 shows the result of a topographic surface image by illustrating SEM images with 5kV electron beam.

Figure 7 is a top view image, which illustrates that no noteworthy scratching or other deformation occurs on the surface 112 of the component carrier structure 102 during processing, there are no protruding glass fibers from the cavity walls, nor other undesired phenomena such as overhanging copper over the cavity edge or different behavior in the vertical wall when crossing the interface regions between materials, for example metal and dielectric, or between dielectrics, such as polymer over glass. The latter is shown in Figure 8 to Figure 9.

Figure 7 illustrates shape and definition of a cavity opening into a substrate. This may be accomplished by cutting through two sheets of copper and a glass reinforced epoxy core.

Figure 8 shows a lateral view of the wall after the cut into a component carrier 102, in particular a glass panel coated with polymer based material on both sides. There may be no difference of the processing surface 112 and the opposed surface of the component carrier 102. The component carrier 102 is cut in a good manner. There is no burr and no delamination among those dielectric layers and conductive layers.

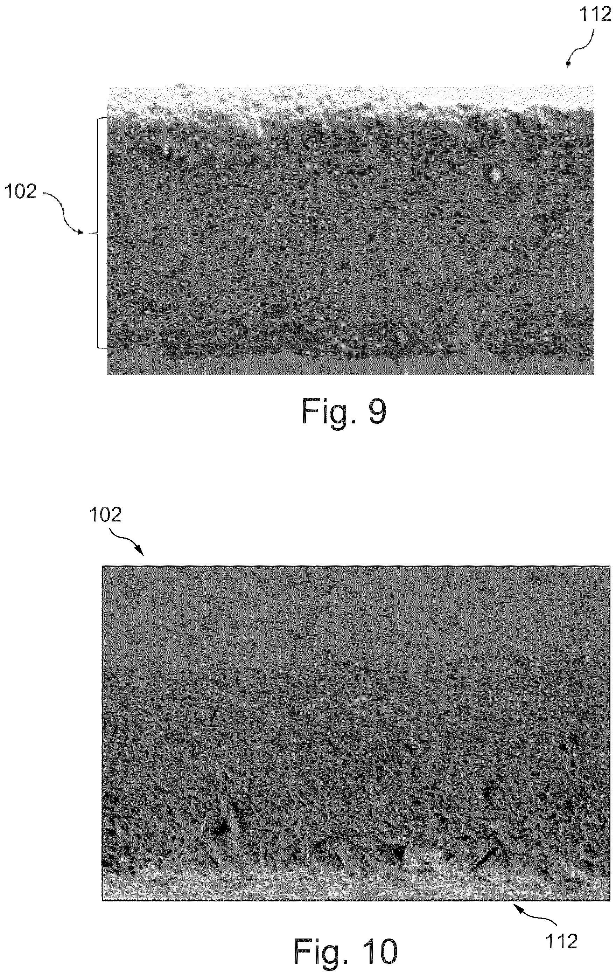

Figure 9 shows a higher magnification of the lateral view of the wall after the waterjet cut into a component carrier 102, in particular a glass panel coated with polymer based material on both sides.

Referring to Figure 10, the water jet may be used to increase the roughness at preferred surface portions, for example a surface of an electrically conductive layer structure and/or a surface of an electrically insulating layer structure. In Figure 10, the top part is an untreated and smooth copper surface, whereas the bottom part is treated by water jet and is roughened copper surface.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A head (100) for exposing a surface (112) of a component carrier structure (102) to a treatment with a processing medium (104), the head (100) comprising:
at least one ejection opening (106) for ejecting the processing medium (104) to the surface (112);
a peripheral wall (108) delimiting a working space (110) to contain the ejected processing medium (104) when the head (100) is in its working position with respect to the surface (112) to be exposed to the processing medium (104); and
a processing medium outlet (118) configured to discharge the ejected processing medium (104) from the working space (110).

2. The head (100) according to claim 1, comprising an electrostatic discharge unit (114) configured to remove at least part of electrostatic charge from the surface (112) to be exposed to the processing medium (104), wherein in particular at least one electrically conductive element and/or the peripheral wall (108) is configured as at least part of the electrostatic discharge unit (114).

3. The head (100) according to any of claims 1 to 2, wherein the at least one ejection opening (106) is configured to eject the processing medium (104) as a jet-beam.

4. The head (100) according to any of claims 1 to 3, wherein the peripheral wall (108) is circumferentially closed so that the head (100) and the surface (112) to be exposed to the processing medium (104) form a closed volume.

5. The head (100) according to any of claims 1 to 4, wherein the peripheral wall (108) is a non-homogeneous structure.

6. The head (100) according to any of claims 1 to 5, wherein the peripheral wall (108) is deformable, in particular elastically deformable.

7. The head (100) according to any of claims 1 to 6, wherein the peripheral wall (108) is a porous wall (108), in particular having closed pores and/or open pores.

8. The head (100) according to any of claims 1 to 7, wherein the peripheral wall (108) comprises fibers (116), in particular electrically conductive fibers such as carbon fibers and/or fibers grouped to form a brush.

9. The head (100) according to any of claims 1 to 8, wherein the peripheral wall (108) is configured to contact the surface (112) to be exposed to the processing medium (104) when the head (100) is in its working position.

10. The head (100) according to any of claims 1 to 9, wherein the processing medium outlet (118) comprises an outlet section directly connected to the working space (110) for draining the processing medium (104).

11. The head (100) according to any of claims 1 to 10, wherein the processing medium outlet (118) has a protruding section (154) which protrudes into an inside of the working space (110).

12. The head (100) according to any of claims 1 to 11, comprising a suction device (120) connected to the processing medium outlet (118) for sucking the processing medium (104) out of the working space (110).

13. An apparatus (122) for processing a surface (112) of a component carrier structure (102) by a processing medium (104), wherein the apparatus (122) comprises a head (100) according to any of claims 1 to 12 for exposing the surface (112) of the component carrier structure (102) to the processing medium (104).

14. The apparatus (122) according to claim 13, wherein the apparatus (122) is configured for removing material of the component carrier structure (102) by the processing medium (104), and/or wherein the apparatus (122) is configured for forming a cavity or a through hole (124) in the component carrier structure (102) by the processing medium (104), and/or wherein the apparatus (122) is configured for singularizing the component carrier structure (102) into a plurality of individual component carriers, in particular printed circuit boards or integrated circuit substrates.

15. A method of exposing a surface (112) of a component carrier structure (102) to a treatment with a processing medium (104), the method comprising:
ejecting the processing medium (104) to the surface (112) by at least one ejection opening (106) of a head (100);
arranging a peripheral wall (108) of the head (100) for delimiting a working space (110) to contain the ejected processing medium (104) when the head (100) is in its working position with respect to the surface (112) exposed to the processing medium (104); and
discharging the ejected processing medium (104) from the working space (110) via a processing medium outlet (118) of the head (100).
